# EUROPEAN PATENT APPLICATION

(11) **EP 1 024 528 A2**
(43) Date of publication of application: **02.08.2000**
(21) Application number: 00101597.3
(22) Date of filing: 27.01.2000
(51) Int. Cl.: H01L 21/8249, H01L 27/06

(54) **Semiconductor device and method for manufacturing same**

(30) Priority: 29.01.1999 JP 2220799
(71) Applicant: NEC CORPORATION, Tokyo (JP)
(72) Inventor: Yoshida, Hiroshi, c/o NEC Corporation, Tokyo (JP)
(74) Representative: Glawe, Delfs, Moll & Partner

(57) **Abstract**

A semiconductor device includes a bipolar transistor (14, 16) having at least a silicified surface layer of an emitter (42), a base (26) and a collector (22), and a MOS transistor (18, 20) including a gate electrode (40) having a silicified surface layer. The silicification of the diffused region of the bipolar transistor (14, 16) facilitates the manufacture of the semiconductor device having a reduced electric resistance.

## Description

### BACKGROUND OF THE INVENTION

### (a) Field of the Invention

The present invention relates to a semiconductor device including a bipolar transistor and a MOS transistor on a semiconductor substrate and a method for manufacturing the same, more in detail to the BiCMOS semiconductor device including the bipolar transistor having a silicified electrode region and the MOS transistor having a gate electrode of which a surface layer is silicified and the method for manufacturing the same.

### (b) Description of the Related Art

With the progress of an engineering work station (EWS) required to have a high-speed performance and a compactness of an apparatus in place of a large-scaled computer, a BiMOS semiconductor device is attracting attention in the field, which utilizes the high-speed performance of the bipolar transistor and a high integration adaptability and low power consumption, and the improvements of the configuration of the BiMOS semiconductor device and the method for manufacturing the same are being actively researched.

Recently, for example, the emitter structure of the bipolar transistor in the BiMOS semiconductor device has been frequently formed in an ion implantation step similarly to that of the MOS transistor.

The emitter structure may include the ion-implanted emitter structure and a solid phase diffused emitter structure depending on methods for manufacture.

The ion-implanted emitter structure is formed by ion-implanting the emitter with a specified concentration of impurities, and the solid phase diffused emitter structure is formed by forming a polysilicon layer having impurities on an emitter-forming region and diffusing the impurities from the polysilicon layer to the emitter-forming region in the solid phase to form the emitter having the specified concentration of the impurities.

In the BiMOS semiconductor device, most of the emitters are formed by ion implantation as described earlier. This is because the emitter of the bipolar transistor can be formed in a step similar to that for forming the source-drain region of the CMOS transistor to largely reduce a manufacturing cost although the transistor characteristics of the ion-implanted emitter structure are somewhat inferior to those of the solid phase diffused emitter structure.

With the miniaturization of the MOS transistors, the gate electrode thereof is subjected to silicification for lowering an interconnect resistance. With the miniaturization, the electric resistance of the source-drain region of the CMOS transistor is also reduced similarly to that of the gate electrode by silicification of the surface layer of the source-drain region because the sheet resistance of the source-drain region is increased due to a shallow junction and a lower impurity concentration in the above miniaturization.

On the other hand, in the BiMOS semiconductor device, the silicification of the electrode is generally conducted only to the MOS transistor side, and the reduction of the electric resistances is not heretofore conceived by conducting the silicification of the base electrode region, the emitter electrode region and the collector region of the bipolar electrode.

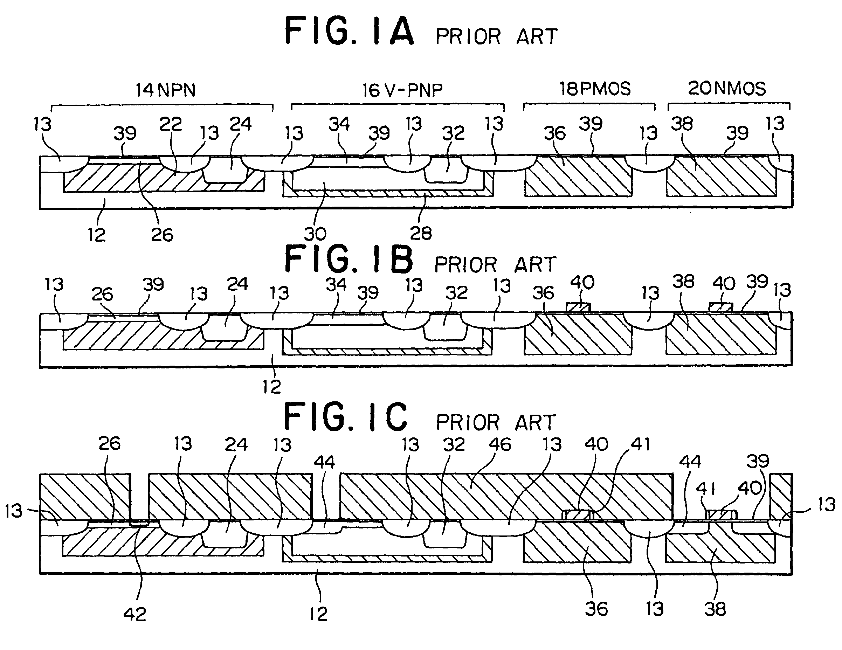

Referring to Figs.1A to 1H, the conventional BiCMOS semiconductor device including the bipolar transistor having the ion-implanted emitter structure and a method for manufacturing the same will be described.

For manufacturing the conventional BiCMOS semiconductor device, an element isolation region (or field oxide film) 13 is formed on a P-type substrate 12, to separately form an NPN bipolar transistor region (hereinafter referred to as "NPN region") 14, a V-PNP bipolar transistor region (hereinafter referred to as "V-PNP region") 16, a PMOS transistor region (hereinafter referred to as "PMOS region") 18 and an NMOS transistor region (hereinafter referred to as "NMOS region") 20, as shown in Fig.1A.

In accordance with ordinary processes, an N-type collector region 22, an N⁺ region 24 and a P-type base region 26 are formed in the NPN region 14. Then, an N-type region 28, a P-type collector region 30, a P⁺ region 32 and an N-type base region 34 are formed in the V-PNP region 16. An N-well 36 and a P-well 38 are formed in the PMOS region 18 and the NMOS region 20, respectively.

A gate oxide film 39 is formed on each of the field regions.

Then, a polysilicon layer is formed over the entire substrate 12 and gate electrodes 40 are patterned on the PMOS region 18 and the NMOS region 20 as shown in Fig.1B.

After formation of side walls 41 around the gate electrodes 40, a resist mask is formed over the regions other than the regions wherein an N-type emitter region 42 and N⁺ regions 44 are to be formed, by means of ion-implantation of N-type impurities, the N-type emitter region 42 in the NPN region 14, the N⁺ region 44 (base electrode region) in the V-PNP region 16 and the N⁺ region 44 (source-drain region) in the NMOS region 20 as shown in Fig.1C.

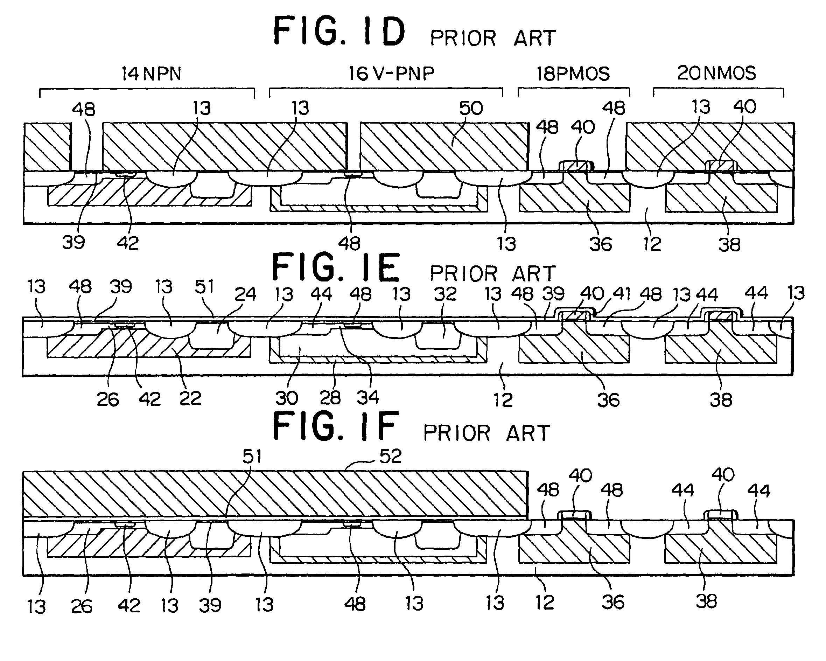

A resist mask 50 is formed over the regions other than the regions wherein P⁺ regions 48 are to be formed, by means of ion-implantation of P-type impurities, the P⁺ region 48 (base electrode region) in the NPN region 14, the P⁺ region 48 (P-type emitter region) in the V-PNP region 16 and the P⁺ region 48 (source-drain region) in the PMOS 18 as shown in Fig.1D.

Then, an oxide film 51 is formed over the entire substrate 12 as shown in Fig.1E.

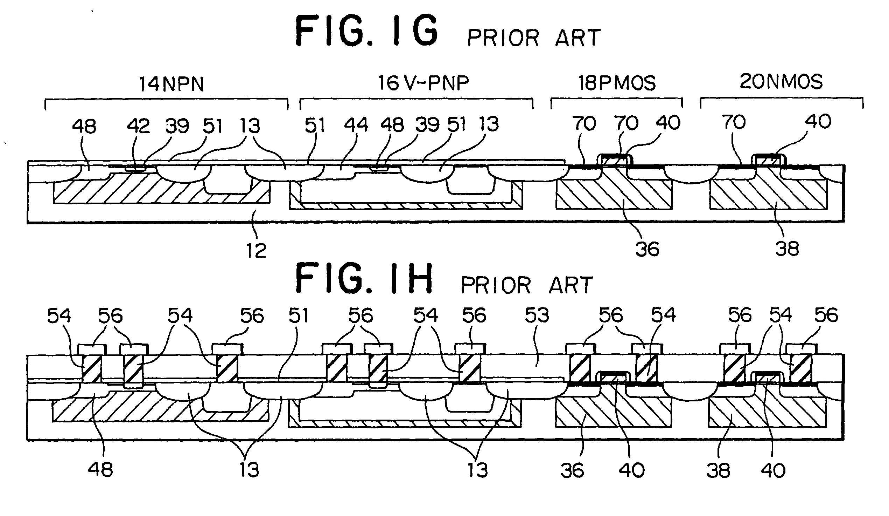

A resist mask 52 is formed, as shown in Fig.1F overlying the NPN region 14 and the V-PNP region 16, and after removal of the oxide film 51 from the PMOS region 18 and the NMOS region 20, the surface layers of the gate electrodes 40, the N⁺ region 44 and the P⁺ region 48 are subjected to silicification for forming silicide layers 70 as shown in Fig.1G.

After an interlayer dielectric layer 53 is formed over the entire substrate 12, via holes are formed through the interlayer dielectric layer 53, which are then filled with tungsten to form via plugs 54 penetrating the interlayer dielectric layer 53. Then, an aluminum alloy layer is deposited on the interlayer dielectric layer 53 and the via plugs 54 and patterned to provide interconnects 56 as shown in Fig.1H.

In accordance with the procedures shown in Figs.1A to 1H, the BiCMOS including the gate electrodes 40 and the source-drain regions 44 and 48 each having the silicified surface layer shown in Fig.1H can be manufactured.

However, with the development of the miniaturization of the BiMOS semiconductor device, the electrode regions of the bipolar transistors are also required to be reduced, which increases the resistances of the electrodes of the bipolar transistor.

### SUMMARY OF THE INVENTION

In view of the foregoing, an object of the present invention is to provide a semiconductor device including a bipolar transistor having a silicified electrode region in addition to a MOS transistor having a silicified gate electrode and a silicified source-drain region.

Another object of the present invention is to provide a method for manufacturing a semiconductor device in which an electrode region of a bipolar transistor can be economically silicified in addition to a gate electrode and a source-drain region of a MOS transistor.

The present invention provides, in a first aspect thereof, a semiconductor device including: a semiconductor substrate; a MOS transistor formed on the semiconductor substrate and including a gate electrode having a silicified surface layer; and a bipolar transistor formed on the semiconductor substrate and including an emitter, a base and a collector, at least one of which has a silicified surface layer.

The present invention provides, in a second aspect thereof, a method for manufacturing a semiconductor device including the steps of: forming a bipolar transistor on a semiconductor substrate; forming a MOS transistor on the semiconductor substrate; forming a circular mask overlying an edge of an emitter-base junction of the bipolar transistor; and subjecting surface layers of a gate electrode and a source-drain region of the MOS transistor and surface layers of a base region, a collector region and an emitter region of the bipolar transistor to silicification by using the circular mask to form silicide layers.

In accordance with the semiconductor device of the present invention in which the surface layer of at least one of the base region, the emitter region and the collector region of the bipolar transistor is silicified in addition to the surface layer of the gate electrode of the MOS transistor, the semiconductor device including the electrode region having a low electric resistance can be realized.

Further, in accordance with the method of the present invention, the surface layers of electrode regions of the bipolar transistor can be economically silicified.

The above and other objects, features and advantages of the present invention will be more apparent from the following description.

### BRIEF DESCRIPTION OF DRAWINGS

Figs.1A to 1H are vertical sectional views showing consecutive steps for conventionally manufacturing a BiCMOS semiconductor device.
Fig.2 is a vertical sectional view showing a semiconductor device in accordance with a first embodiment of the present invention.
Fig.3 is a vertical sectional view showing a semiconductor device in accordance with a second embodiment.
Fig.4 is a vertical sectional view showing a semiconductor device in accordance with a third embodiment.
Fig.5 is a plan view showing a ring mask of the semiconductor device of Fig.4.
Fig.6 is a vertical sectional view showing a semiconductor device in accordance with a fourth embodiment.
Fig.7 is a vertical sectional view showing a semiconductor device in accordance with a fifth embodiment.
Figs.8A to 8C are vertical sectional views showing consecutive steps for manufacturing the semiconductor device of the first embodiment.
Figs.9A to 9C are vertical sectional views showing consecutive steps for manufacturing the semiconductor device of the second embodiment.
Figs.10A to 10E are vertical sectional views showing consecutive steps for manufacturing the semiconductor device of the third embodiment.
Figs.11A to 11F are vertical sectional views showing consecutive steps for manufacturing the semiconductor device of the fourth embodiment.
Figs.12A and 12B are vertical sectional views showing consecutive steps for manufacturing the semiconductor device of the fifth embodiment.

### PREFERRED EMBODIMENTS OF THE INVENTION

Now, the present invention is more specifically described with reference to accompanying drawings.

### First Embodiment

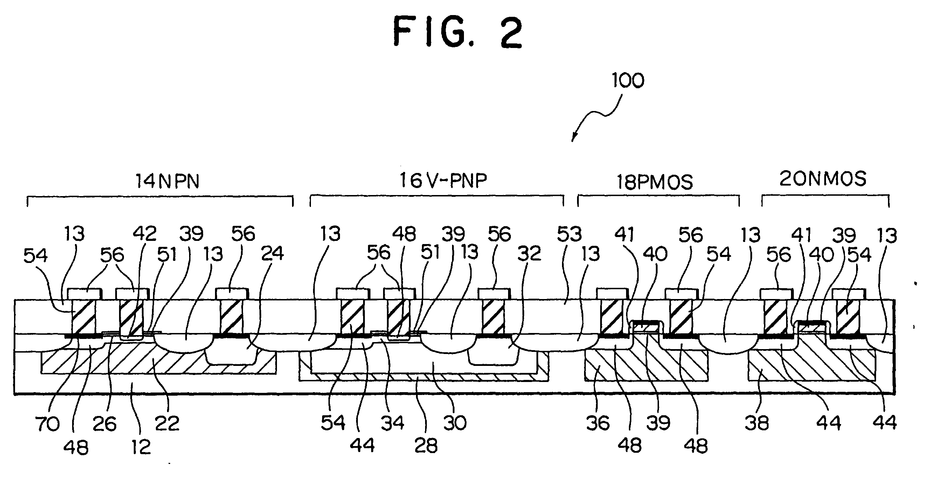

Referring to Fig.2, a BiCMOS semiconductor device 100 in accordance with a first embodiment includes an element isolation region (formed by field oxide film) 13 on a p-type substrate 12, to separately form an NPN bipolar transistor region (hereinafter referred to as "NPN region") 14, a V-PNP bipolar transistor region (hereinafter referred to as "V-PNP region") 16, a PMOS transistor region (hereinafter referred to as "PMOS region") 18 and an NMOS transistor region (hereinafter referred to as "NMOS region") 20.

The NPN region 14 includes an N-type collector region 22, an N⁺ collector electrode region 24, a P-type base region 26, P⁺ base electrode region 48 and an N-type emitter region 42 at specified positions.

The V-PNP region 16 includes an N-type region 28, a P-type collector region 30, a P⁺ collector electrode region 32, an N-type base region 34, an N⁺ base electrode region 44 and a P-type emitter region 48 at specified positions.

The N-type emitter region 42 of the NPN region 14 and the P-type emitter region 48 of the V-PNP region 16 are formed by the ion implantation.

In the PMOS region 18, an N-well 36 having therein a pair of P⁺ source-drain regions 48 is formed. A gate electrode 40 having a side wall 41 is formed between the P⁺ source-drain regions 48 on the N-well 36, with intervention of a gate oxide film 39.

In the NMOS region 20, a P-well 38 having therein a pair of N⁺ source-drain regions 44 is formed. A gate electrode 40 having a side wall 41 is formed between the N⁺ source-drain regions 44 on the P-well 38, with intervention of a gate oxide film 39.

Similarly to the conventional BiCMOS semiconductor device, the surface layers of the P⁺ source-drain regions 48, the N⁺ source-drain regions 44 and the gate electrode 40 of the PMOS region 18 and the NMOS region 20 are silicified to form silicide layers 70 composed of, for example, CoSi.

Further, in the NPN region 14 of the semiconductor device, the surface layers of the N⁺ region 24 and the P⁺ region 48 are silicified to form the silicide layers 70 composed of, for example, CoSi. In the V-PNP region 16, the surface layers of the P⁺ region 32 and the N⁺ region 44 are silicified to form the silicide layers 70 composed of, for example, CoSi.

In both of the NPN and the PNP regions 14 and 16, emitter-base junctions existing on the surface of the silicon substrate 12 are covered by oxide films 51. The oxide films 51 are used as a mask during silicification and the emitter-base junctions are not short-circuited during the silicification.

After an interlayer dielectric layer 53 is formed over the entire substrate 12, via holes are formed through the interlayer dielectric layer 53, which are then filled with tungsten to form via plugs 54 penetrating the interlayer dielectric layer 53. The respective via plugs 54 are connected with the N⁺ region 24, the N-type emitter region 42 and the P⁺ region 48 of the NPN region 14; the P⁺ region 32, the P-type emitter region 48 and the N⁺ region 44 of the V-PNP region 16; the P-type emitter region 48 of the PMOS region 18 and the N⁺ region 44 of the NMOS region 20.

Then, aluminum alloy interconnects 56 are formed on the interlayer dielectric layer 53 and connected with the top ends of the via plugs 54.

### Second Embodiment

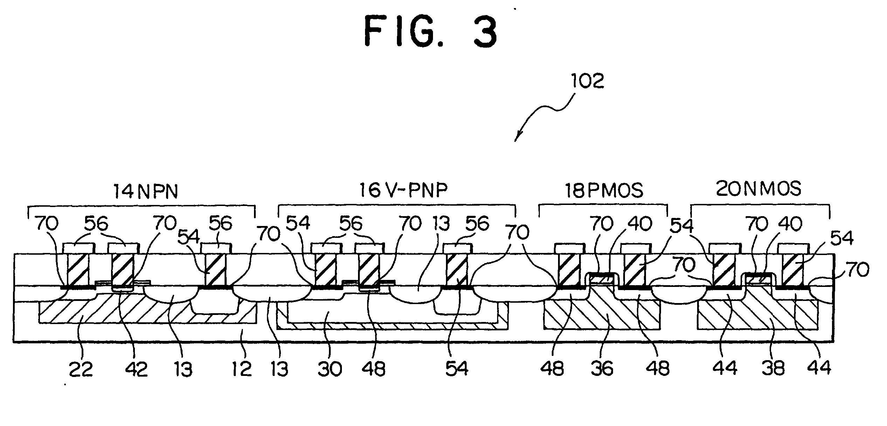

Referring to Fig.3, a BiCMOS semiconductor device 102 according to a second embodiment is substantially the same as the semiconductor device 100 of the first second embodiment except that silicified surface layers of an N-type emitter 42 of an NPN region 14 and of a P-type emitter region 48 of a V-PNP emitter region 16 are provided to form silicide layers 70 composed of, for example, CoSi.

### Third Embodiment

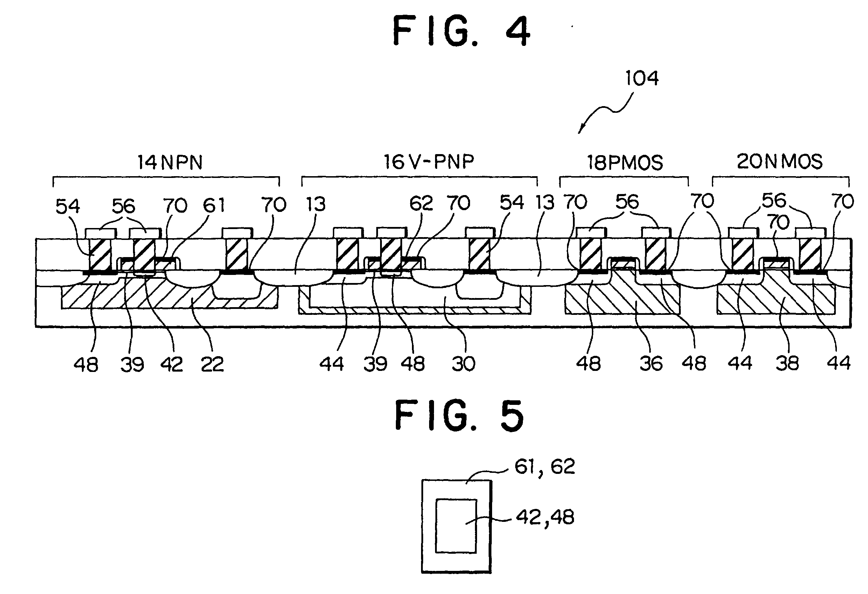

A BiCMOS semiconductor device 104 according to a third embodiment shown in Figs.4 and 5 is substantially the same as the semiconductor device 100 of the second embodiment except for the followings.

Different from the configuration of the N-type emitter region 42 of the NPN region 14 and the P-type emitter region 48 of the V-PNP region 16 of the second embodiment, an N-type emitter region 42 and a P-type emitter region 48 of the third embodiment surrounded by patterned ring (having a circular or a cylindrical shape) masks 61 and 62 composed of a polysilicon layer are formed in a step the same as that of forming gate electrodes 40 of a PMOS region 18 and a NMOS region 20 as shown in Fig.4.

The ring masks 61 and 62 circularly surround the emitter regions 42 and 48, respectively, as shown in Fig.5. The surface layers of the ring masks 61 and 62 are silicified to form silicide layers 70.

In both of the NPN and the PNP regions 14 and 16, emitter-base junctions existing on the surface of the silicon substrate 12 are covered with oxide films 39 and the ring masks 61 and 62. Thus, the silicification can be completed without short-circuit of the emitter-base junctions.

### Fourth Embodiment

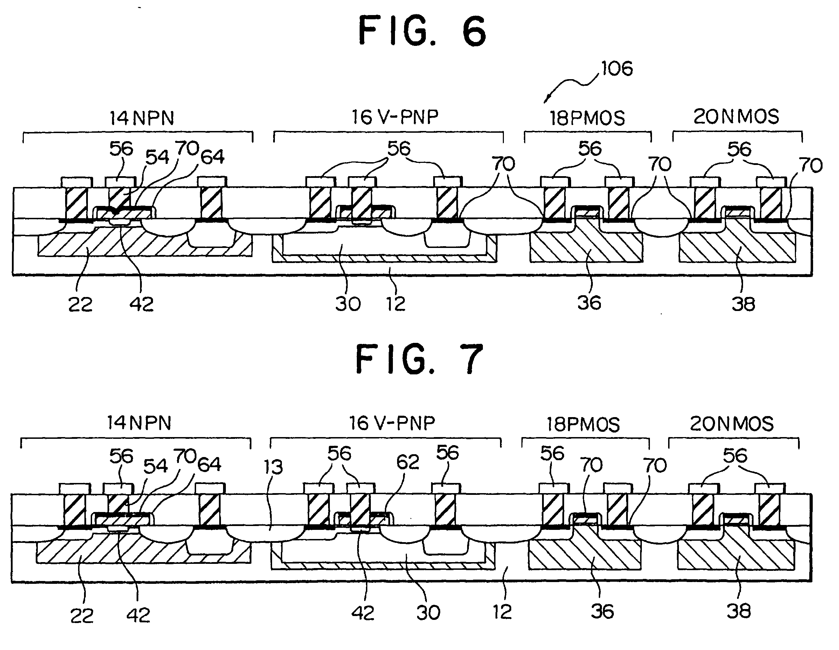

Referring to Fig.6, a BiCMOS semiconductor device 106 according to a fourth embodiment is substantially the same as the semiconductor device 104 of the third embodiment except for the followings.

Different from the configuration of the N-type emitter region 42 of the NPN region 14, an N-type emitter region 42 of the present embodiment is formed by means of a solid phase diffusion method. A polysilicon layer 64 acting as a source of N-type impurities is formed overlying the N-type emitter 42, and the N-type emitter 42 is connected with an interconnect 56 by way of the polysilicon layer 64 and a via plug 54. The surface layer of the polysilicon layer 64 is silicified to form the silicide layer 70.

### Fifth Embodiment

Referring to Fig.7, a BiCMOS semiconductor device 108 according to a fifth embodiment is substantially the same as the semiconductor device 106 of the fourth embodiment except for the followings.

Referring to Fig.7, a ring mask 62 surrounding a P-type emitter 42 of a V-PNP region 16 of the semiconductor device 108 of the present embodiment has substantially the same shape as the ring mask 62 of the V-PNP region 16 of the fourth embodiment. However, different from the ring mask 62 of the fourth embodiment, the ring mask 62 of the present embodiment is formed in a step of forming the polysilicon layers 64 acting as a source of N-type impurities together with the polysilicon layers 64.

### First Example of Manufacturing Semiconductor Device

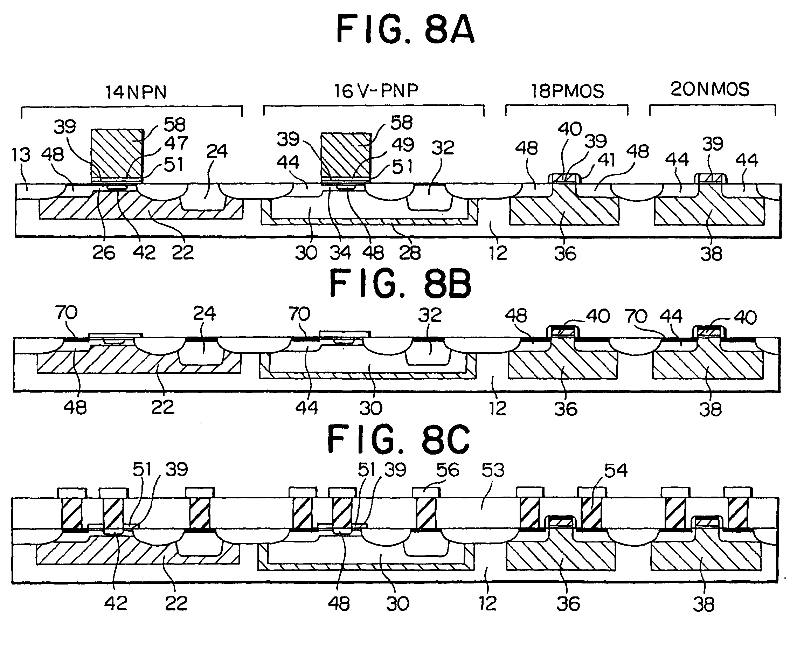

Referring to Figs.8A to 8C showing consecutive steps for manufacturing the semiconductor device of the first embodiment, the N-type collector region 22, the N⁺ collector electrode region 24 and the P-type base region 26 are formed in the NPN region 14 overlying the substrate 12, and the N-type region 28, the P-type collector region 30, the P⁺ collector electrode region 32 and the N-type base region 34 are formed in the V-PNP region 16 overlying the substrate 12 in accordance with the above-described conventional procedures. The N-well 36 and the P-well 36 are formed in the PMOS region 18 and the NMOS region 20, respectively.

The gate oxide film 39 is grown on each of the field regions.

The gate electrodes 40 and the side walls 41 formed around the gate electrodes 40 are formed on the PMOS region 18 and the NMOS region 20. Then, the N-type emitter region 42 and the N⁺ region 44 are formed by means of ion implantation of N-type impurities followed by the formation of the P⁺ regions 48 by means of ion implantation of P-type impurities.

The oxide film 51 is formed to provide the semiconductor wafer shown in Fig.1E.

In the present example, the manufacture further proceeds with the formation of masks 58 composed of a resist film. As shown in Fig.8A, the mask 58 in the NPN region 14 covers a circular isolation region 47 surrounding the emitter region 42 for isolating the emitter region 42 from the base region 48, and the mask 58 in the V-PNP region 16 covers the emitter region 48 and a circular isolation region 49 surrounding the emitter region 48 for isolating the emitter region 48 from the base region 44. The regions other than those covered with the masks 58 are exposed.

Then, the oxide film 51 is etched by employing the masks 58 so that the oxide film 51 in the NPN region 14 covers the emitter region 42 and the isolation region 47 and the oxide film 51 in the V-PNP region 16 covers the emitter region 48 and the isolation region 49.

After the removal of the resist mask 58, silicification is conducted by employing the oxide film 51 as a mask, that is, the surface layers of the base region 48 and the collector region 24 in the NPN region 14, the surface layers of the base region 44 and the collector region 32 in the V-PNP region 16, the surface layers of the gate electrode 40 and the source-drain region 48 in the PMOS region 18 and the surface layers of the gate electrode 40 and the source-drain region 44 in the NMOS region 20 are silicified to form the silicide layer 70 as shown in Fig.8B. A high melting point metal employed for the silicification is not restricted, and such a metal as Co and W can be used.

Then, perforations are formed through the oxide films 39 and 51 for exposing the emitter regions 42 and 48. After the formation of the interlayer dielectric film 53 on the entire substrate 12, via holes are formed through the interlayer dielectric layer 53, which are then filled with tungsten to form the via plugs 54 penetrating the interlayer dielectric layer 53. Then, the aluminum alloy layer is deposited and patterned to form the interconnects 56 as shown in Fig.8C.

In accordance with the above procedures, the semiconductor device 100 of the first embodiment can be manufactured.

### Second Example of Manufacturing Semiconductor Device

A method of a second example is obtained by modifying the first example. The method is used for manufacturing the semiconductor device of the second embodiment.

At first, the semiconductor wafer shown in Fig.1E is manufactured similarly to the procedures of the first example.

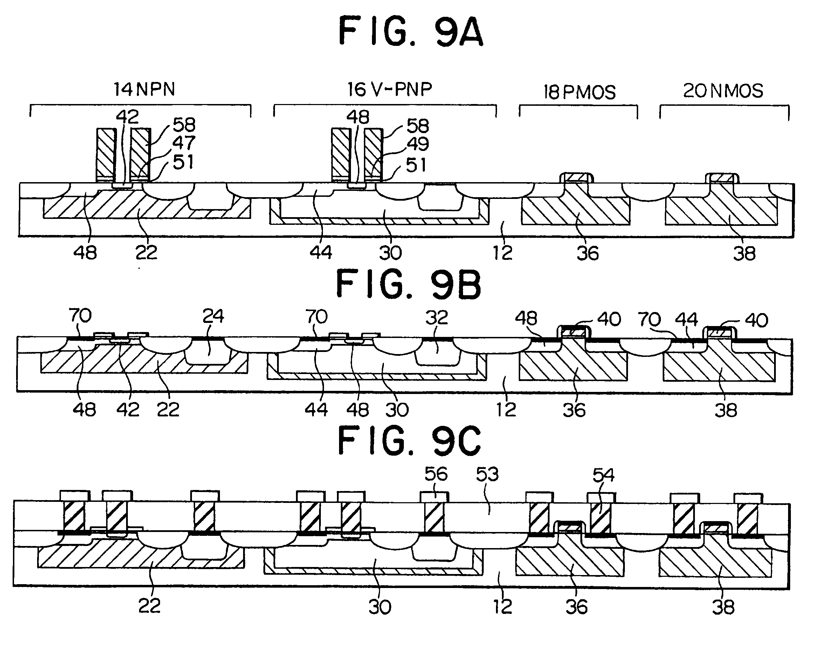

Referring to Fig.9A, masks 58 composed of a resist film are formed. As shown therein, the mask 58 in the NPN region 14 exposes the emitter region 42 and covers a circular isolation region 47 surrounding the emitter region 42 for isolating the emitter region 42 from the base region 48, and the mask 58 in the V-PNP region 16 exposes the emitter region 48 and covers the emitter region 48 and a circular isolation region 49 surrounding the emitter region 48 for isolating the emitter region 48 from the base region 44. The regions other than those covered with the masks 58 are exposed.

Then, the oxide film 51 is etched by employing the masks 58 so that the oxide film 51 in the NPN region 14 covers the isolation region 47 surrounding the emitter region 42 for isolating the base region 48, and the oxide film 51 in the V-PNP region 16 covers the isolation region 49 surrounding the emitter region 42 for isolating the base region 48.

After the removal of the resist mask 58, silicification is conducted by employing the oxide film 51 as a mask, that is, the surface layers of the base electrode region 48, the emitter region 42 and the collector region 24 in the NPN region 14, the surface layers of the base electrode region 44, the emitter region 48 and the collector region 32 in the V-PNP region 16, the surface layers of the gate electrode 40 and the source-drain region 48 in the PMOS region 18 and the surface layers of the gate electrode 40 and the source-drain region 44 in the NMOS region 20 are silicified to form the silicide layer 70 as shown in Fig.9B. A high melting point metal employed for the silicification is not restricted, and such a metal as Co and W can be used.

After the formation of the interlayer dielectric film 53 on the entire substrate 12, via holes are formed through the interlayer dielectric layer 53, which are then filled with tungsten to form the via plugs 54 penetrating the interlayer dielectric layer 53. Then, the aluminum alloy layer is deposited and patterned to form the interconnects 56.

In accordance with the above procedures, the semiconductor device 102 of the second embodiment can be manufactured.

### Third Example of Manufacturing Semiconductor Device

The first and the second examples need the formation of the masks 58 for silicifying the electrode regions of the NPN region 14 and the V-PNP region 16 to require an additional photolithographic etching process. A third example provides an alternate method which does not require the additional photolithographic etching process by improving the first and the second examples.

A method of the third example is to manufacture the semiconductor device 104 of the third embodiment.

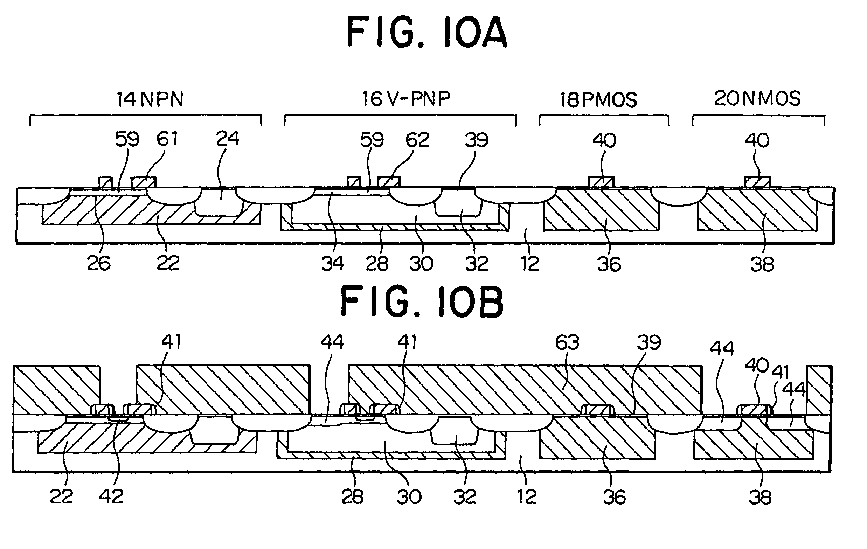

Referring to Figs.10A to 10E showing consecutive steps for manufacturing the semiconductor device of the third embodiment, the N-type collector region 22, the N⁺ collector electrode region 24 and the P-type base region 26 are formed in the NPN region 14 overlying the substrate 12, and the N-type region 28, the P-type collector region 30, the P⁺ collector electrode region 32 and the N-type base region 34 are formed in the V-PNP region 16 overlying the substrate 12 in accordance with the above-described conventional procedures. The N-well 36 and the P-well 38 are formed in the PMOS region 18 and the NMOS region 20, respectively.

The gate oxide film 39 is grown on each of the field regions, thereby providing the semiconductor wafer shown in Fig.1A.

Then, after the formation of the polysilicon layer on the entire substrate 12, the gate electrodes are formed in the PMOS region 18 and the NMOS region 20. Simultaneously, by the patterning of the polysilicon layer, the ring masks 61 and 62 are formed in the NPN region 14 and the V-PNP region 16, respectively, as shown in Fig.5. The regions other than those covered with the masks 61 and 62 are exposed.

After formation of the side walls 41 around the gate electrodes 40 and the ring masks 61 and 62, a mask 63 covering the region excluding the N-type emitter region 42 (emitter formed region 59) in the NPN region 14 and the N⁺ regions 44 (base formed region 59) in the V-PNP region 16 is formed. Then, ion implantation of N-type impurities forms the N-type emitter region 42 in the NPN region 14 and the N⁺ regions 44 in the V-PNP region 16. The N⁺ source-drain region 44 is also formed in the NMOS region 20.

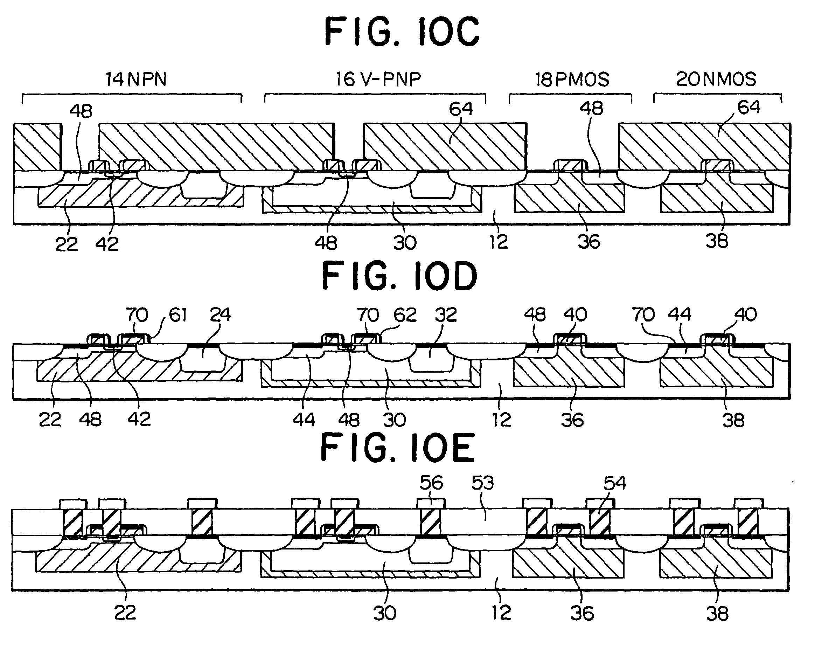

As shown in Fig.10C, the mask 64 covering the region other than the P⁺ regions 48 is formed for conducting ion implantation to form the P⁺ regions 48 in the NPN region 14, the V-PNP region 16 and the PMOS region 18 acting as a base electrode region, an emitter region and a source-drain region, respectively.

The surface layers of the N-type emitter region 42, the base electrode region 48 and the collector electrode region 24 of the NPN region 14, the surface layers of the base electrode region 44, the emitter region 48 and the collector electrode region 32 of the V-PNP region 16, the surface layers of the gate electrode region 40 and the source-drain region 48 of the PMOS region 18 and the surface layers of the gate electrode region 40 and the source-drain region 44 of the NMOS region 20 are silicified to form the silicide layers 70 as shown in Fig.10D.

After the interlayer dielectric layer 53 is formed on the entire substrate 12, via holes are formed through the interlayer dielectric layer 53, which are then filled with tungsten to form via plugs 54 penetrating the interlayer dielectric layer 53 as shown in Fig.10E. Then, an aluminum alloy layer is deposited on the interlayer dielectric layer 53 and the via plugs 54 and patterned to provide interconnects 56.

In accordance with the above procedures, the semiconductor device 104 of the third embodiment can be manufactured.

In the present example, the positions of the via plugs 54 can be self-aligned by employing the ring masks 61 and 62 when the via plugs 54 are formed in the emitter region 42 of the NPN region 14 and the emitter region 48 of the V-PNP region 16.

### Fourth Example of Manufacturing Semiconductor Device

A method of a fourth example is to manufacture the semiconductor device 106 of the fourth embodiment.

Referring to Figs.11A to 11F showing consecutive steps for manufacturing the semiconductor device of the fourth embodiment, the N-type collector region 22, the N⁺ collector electrode region 24 and the P-type base region 26 are formed in the NPN region 14 overlying the substrate 12, and the N-type region 28, the P-type collector region 30, the P⁺ collector electrode region 32 and the N-type base region 34 are formed in the V-PNP region 16 overlying the substrate 12 in accordance with the above-described conventional procedures. The N-well 36 and the P-well 36 are formed in the PMOS regions 18 and the NMOS region 20, respectively.

The gate oxide film 39 is grown on each of the field regions, thereby providing the semiconductor wafer shown in Fig.11A.

After the formation of the polysilicon layer on the entire substrate 12, the gate electrodes 40 are formed in the PMOS region 18 and the NMOS region 20 by means of patterning as shown in Fig.11A. Simultaneously, by the patterning of the polysilicon layer, the ring mask 62 is formed in the V-PNP region 16. The regions other than those covered with the mask 62 are exposed.

As shown in Fih.11B, the oxide layer 51 is formed on the entire substrate 12 and an aperture is formed penetrating the oxide film 51 and the gate oxide film 39 to expose the P-type base region 26 of the NPN region 14. Subsequently, the polysilicon layer including N-type impurities is formed on the entire substrate to form an emitter plug 65.

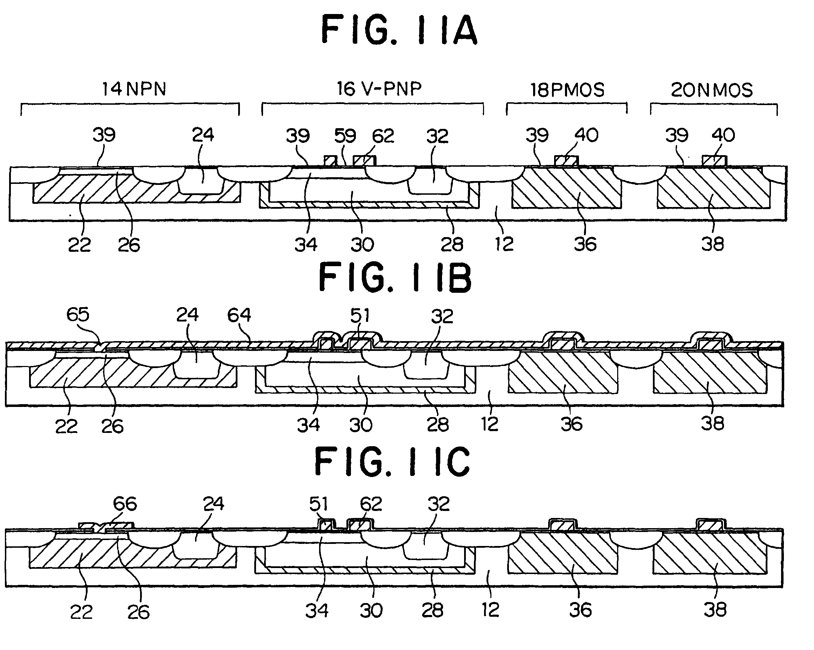

The patterning of the polysilicon layer provides an emitter-polysilicon electrode 66 in the NPN region 14 as shown in Fig.11C.

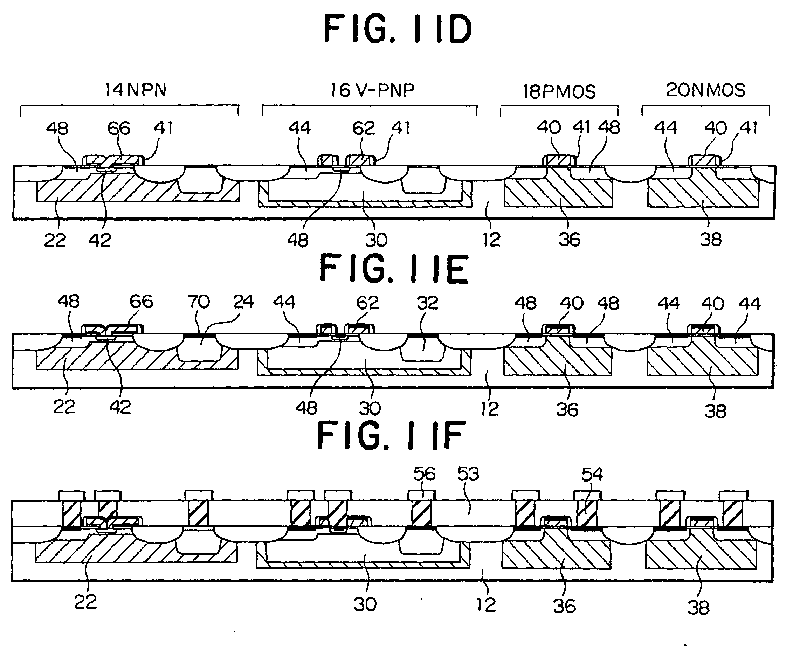

After formation of side walls 41 around the emitter-polysilicon electrodes 66, the ring mask 62 and the respective gate electrodes 40 as shown in Fig.11D, the N⁺ regions 44 and P⁺ region 48 are formed similarly to the first example. In the present example, the N-type emitter region 42 of the NPN region 14 is formed by means of the solid phase diffusion method, and the emitter region 48 of the V-PNP 16 is formed by means of the ion implantation.

The surface layers of the emitter-polysilicon electrode 66, the P⁺ base electrode region 48 and the N⁺ collector electrode region 24 of the NPN region 14, the surface layers of the N+ base electrode region 44, the P-type emitter region 48, the ring mask 62 and the collector electrode region 32 of the V-PNP region 16, the surface layers of the gate electrode 40 and P⁺ source-drain region 48 of the PMOS region 18 and the surface layers of the gate electrode 40 and N⁺ source-drain region 44 of the NMOS region 20 are silicified to form the silicide layers 70 as shown in Fig.11E.

After the interlayer dielectric layer 53 is formed on the entire substrate 12, via holes are formed through the interlayer dielectric layer 53, which are then filled with tungsten to form via plugs 54 penetrating the interlayer dielectric layer 53. Then, an aluminum alloy layer is deposited on the interlayer dielectric Layer 53 and the via plugs 54 and patterned to provide interconnects 56 as shown in Fig.11F.

In accordance with the above procedures the semiconductor device 106 of the fourth embodiment can be manufactured.

### Fifth Example of Manufacturing Semiconductor Device

A method of a fifth example is to manufacture the semiconductor device 108 of the fifth embodiment.

In the present example, at first, the semiconductor wafer shown in Fig. 11B excluding the ring mask is formed.

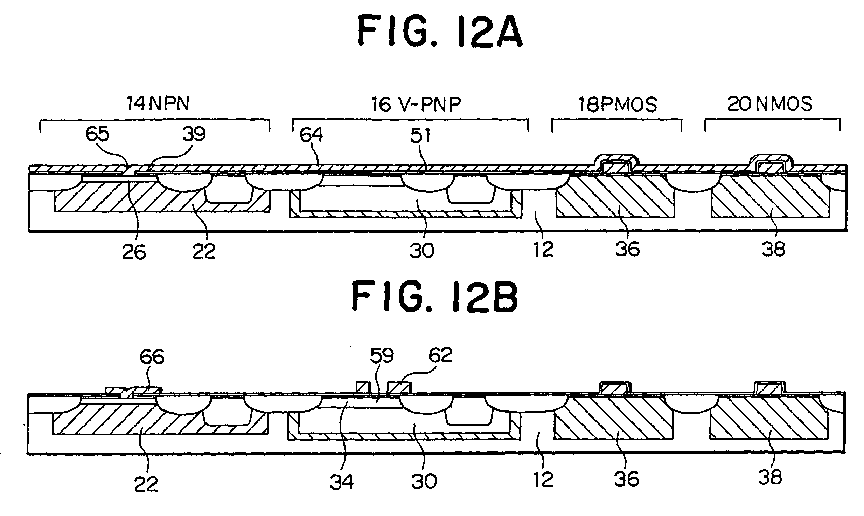

Then, as shown in Fig.12A, the oxide layer 51 having a thickness of 500 to 1000 Å is formed on the entire substrate 12 and an aperture is formed penetrating the oxide film 51 and the gate oxide film 39 to expose the P-type base region 26 of the NPN region 14. Subsequently, the polysilicon layer including N-type impurities is formed on the entire substrate to form an emitter plug 65.

The patterning of the polysilicon layer provides an emitter-polysilicon electrode 66 in the NPN region 14 and the circular ring mask 62 surrounding the base region 34 in the V-PNP region 16 as shown in Fig. 12B.

Thereafter, similarly to the procedures of the fourth example, side walls, silicide layers, interlayer dielectric layers and interconnects are sequentially formed.

In each of the embodiments and the examples, the P-type substrate may be replaced with an N-type substrate.

The composition of the silicide layers of the present invention is not restricted as long as an alloy including a high melting point metal and silicon is employed and the alloy such as CoSi, WSi, TiSi and NiSi are preferable.

Since the above embodiments are described only for examples, the present invention is not limited to the above embodiments and various modifications or alternations can be easily made therefrom by those skilled in the art without departing from the scope of the present invention.

## Claims

1. A semiconductor device comprising:
a semiconductor substrate (12);
a MOS transistor (18, 20) including a gate electrode (40) overlying the semiconductor substrate (12), and
a bipolar transistor (14, 16) including an emitter (42), a base (26) and a collector (22) overlying the semiconductor substrate (12)
characterized in that the gate electrode (40) of the MOS transistor (18, 20) and at least one of the emitter (42), the base (26) and the collector (22) of the bipolar transistor (14, 16) include silicified surface layers.

2. The semiconductor device as defined in claim 1, wherein an emitter-base junction of the bipolar transistor (14, 16) has a circular edge covered by a circular polysilicon layer (64) and an oxide film (39) underlying the polysilicon layer (64).

3. The semiconductor device as defined in claim 2, wherein the circular polysilicon layer (64) and the gate electrode (40) of the MOS transistor (18, 20) are formed from a common layer.

4. The semiconductor device as defined in claim 3, wherein the bipolar transistor includes an NPN bipolar transistor (14) having a solid phase diffused emitter (42) and a PNP transistor (16) having an ion-implanted emitter (48), and the circular polysilicon layer (64) of the PNP transistor (16) and the gate electrode (40) of the MOS transistor (18, 20) are formed from a common layer.

5. A method for manufacturing a semiconductor device comprising the steps of:
forming a bipolar transistor (14, 16) on a semiconductor substrate (12);
forming a MOS transistor (18, 20) on the semiconductor substrate (12);
forming a circular mask (61, 62) overlying an edge of an emitter-base junction of the bipolar transistor (14, 16); and
subjecting surface layers of a gate electrode (40) and a source-drain region of the MOS transistor (18, 20) and surface layers of a base region (26), a collector region (22) and an emitter region (42) of the bipolar transistor (14, 16) to silicification by using the circular mask (61, 62) to form silicide layers (70).

6. The method as defined in claim 5, wherein the method further comprises, between the step of forming the MOS transistor (18, 20) and the step of forming the mask (61, 62), the step of forming an oxide film (39) overlying the entire substrate (12).

7. The method as defined in claim 5, wherein the step of forming the bipolar transistor (14, 16) includes ion-implantation for forming the emitter (42).

8. The method as defined in claim 5, wherein the bipolar transistor includes an NPN bipolar transistor (14) having a solid phase diffused emitter (42) and a PNP bipolar transistor (16) having an ion-implanted emitter (48), and the circular mask (62) of the PNP transistor (16) and the gate electrode (40) of the MOS transistor (18, 20) are formed from a common layer.

9. The method as defined in claim 8, wherein the NPN bipolar transistor (14) includes a doped polysilicon layer (64) for solid phase diffusion on the emitter (42), and the doped polysilicon layer (64) and the gate electrode (40) of the MOS transistor (18, 20) are formed from the common layer.
